Europäisches Patentamt

European Patent Office

Office européen des brevets

(19)

(11) Numéro de publication: **0 202 988 B1**

# FASCICULE DE BREVET EUROPEEN

(12)

(45) Date de publication de fascicule du brevet:
**18.09.91**

(21) Numéro de dépôt: **86400921.2**

(22) Date de dépôt: **25.04.86**

(51) Int. Cl.⁵: **F27B 9/04**, F27B 9/30,
F27D 7/04, F26B 21/14,
H05K 3/12

(54) Four de cuisson de substrat de circuit imprimé.

(30) Priorité: **15.05.85 FR 8507399**

(43) Date de publication de la demande:
**26.11.86 Bulletin 86/48**

(45) Mention de la délivrance du brevet:
**18.09.91 Bulletin 91/38**

(84) Etats contractants désignés:
**DE GB IT NL SE**

(56) Documents cités:
**DE-A- 1 508 539**
**GB-A- 2 135 032**
**US-A- 3 086 764**
**US-A- 3 415 503**

(73) Titulaire: **THOMSON-CSF**
**173, boulevard Haussmann**
**F-75379 Paris Cedex 08(FR)**

(72) Inventeur: **Chambre, Jacques**
**THOMSON-CSF SCPI 19, avenue de Messine**
**F-75008 Paris(FR)**

(74) Mandataire: **Benoit, Monique et al**
**THOMSON-CSF SCPI**
**F-92045 PARIS LA DEFENSE CEDEX 67(FR)**

## Description

La présente invention concerne la fabrication des circuits imprimés. Elle concerne plus spécialement la fabrication des substrats de circuits imprimés, par exemple multicouches, par dépôt sérigraphique, sur un substrat isolant, d'une encre conductrice et d'une encre isolante.

La cuisson est une opération primordiale dans la fabrication d'un tel substrat. C'est en effet lors de ce traitement thermique à très haute température que les matériaux acquièrent leurs propriétés mécaniques et électriques, et que les résines polymères ou autres constituants organiques qui constituent le lien temporaire des encres sont éliminées.

· Les fours actuellement utilisés pour réaliser cette opération de cuisson ont été plus spécialement conçus pour la cuisson sous atmosphère oxydante (Air) d'encres de sérigraphie conductrices à base de métaux nobles tels que l'or.

Ce sont des fours continus, à tapis transporteur, munis d'accès vers l'extérieur permettant l'introduction et la réception des substrats, de moyens d'injection de gaz permettant de réaliser la cuisson sous l'atmosphère souhaitée (l'air pour les encres de sérigraphie à base de métaux nobles) et de moyens d'extraction de gaz permettant d'extraire les résidus obtenus par élimination des résines polymères en cours de cuisson.

L'élimination des résines polymères, qui a lieu au début du cycle de cuisson entre 250° C et 500° C, donne comme produit des gaz réducteurs.

Lorsque la cuisson se fait sous air, ce qui est le cas pour les encres de sérigraphie à base de métaux nobles, ces gaz réducteurs se combinent avec l'oxygène de l'air avant d'être éliminés par les moyens d'extraction.

En revanche lorsque l'encre de sérigraphie utilisée est à base de métal non noble, tel que le cuivre, la cuisson nécessite une atmosphère d'azote (gaz neutre) à très faible concentration d'oxygène (pression partielle d'oxygène $\leqslant 10^5$) afin d'éviter l'oxydation du cuivre due à la réactivité de celui-ci.

La cuisson sous atmosphère non oxydante soulève alors un problème fondamental qui est l'élimination rapide de ces gaz réducteurs. En effet, si certaines conditions sont réunies (proportion et type de polymère, régime des gaz et taux de chargement du four) la présence de ces gaz réducteurs peut sérieusement affecter les propriétés des matériaux. Or les fours utilisés actuellement ne permettent par de résoudre ce problème.

Suivant l'invention, un four de cuisson de substrat de circuit est défini selon la revendication 1. Les revendications 2 à 6 concernent des modes de réalisation particuliers du four

Suivant une autre caractéristique de l'invention les moyens pour assurer un balayage des gaz réducteurs en direction des moyens d'extraction sont obtenus sans aucune adjonction d'éléments supplémentaires, par simple modification et amélioration des éléments existants.

Les objets et caractéristiques de la présente invention apparaîtront plus clairement à la lecture de la description suivante d'un exemple de réalisation, faite en relation avec les dessins ci-annexés dans lesquels :

- la figure 1 est une vue, suivant une coupe longitudinale, d'un four suivant l'invention ;
- les figures 2 et 3 sont deux vues, en coupe longitudinale, de moyens d'extraction équipant un four suivant l'invention.

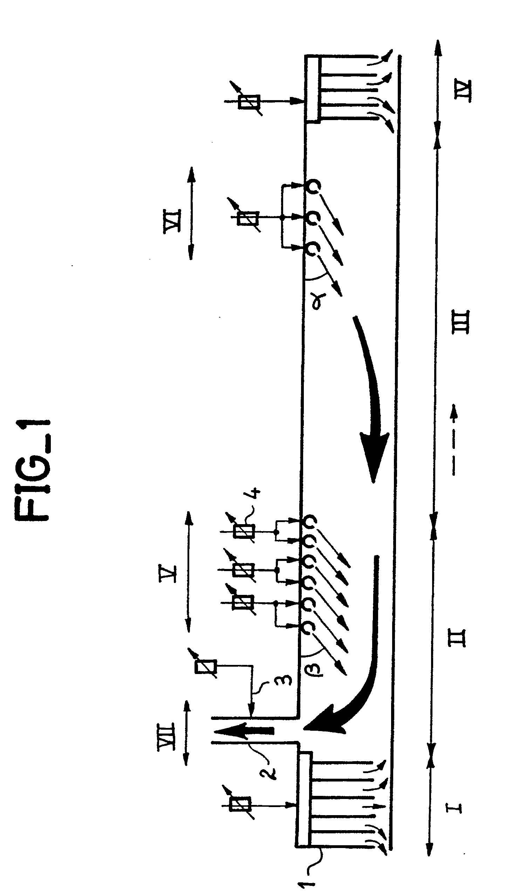

Les températures régnant à l'intérieur du four représenté sur la figure 1 sont telles que celui-ci comporte une zone de précuisson II, dans laquelle la température évolue jusqu'à 700° C environ, suivie d'une zone de cuisson III dans laquelle la température évolue jusqu'à 900° C environ. Les substrats à cuire se déplacent à l'intérieur du four de l'entrée I, par laquelle ils sont introduits, vers la sortie IV par laquelle ils sont extraits, en passant successivement par la zone de précuisson II puis par la zone de cuisson III, c'est-à-dire suivant le sens de la flèche en pointillés.

Une injection d'azote est réalisée au niveau de l'entrée et de la sortie du four. L'entrée et la sortie du four sont également équipées de rideaux métalliques 1 destinés à éviter des entrées d'air.

Des moyens d'injection d'azote, localisés en V et VI, sont prévus respectivement dans la zone de précuisson et dans la zone de cuisson. Des moyens d'extraction, localisés en VII, des résidus organiques (ou gaz réducteurs) produits par chauffage des résines polymères sont également prévus. Ces moyens d'injection d'azote consistent par exemple en des rangées de tubes, ces tubes étant disposés transversalement (seule leur section circulaire apparaissant sur la coupe de la figure 1) et étant percés de trous et reliés à un réservoir d'azote. Les moyens d'extraction de gaz réducteurs consistent par exemple en une cheminée 2 munie d'un système d'injection 3 (représenté très schématiquement par une flèche brisée) permettant de renforcer son efficacité.

Les gaz réducteurs produits par chauffage des résines polymères sont produits par des réactions qui ont lieu entre 250° C et 500° C, soit dans la zone de précuisson.

Les moyens de balayage de ces gaz réducteurs en direction des moyens d'extraction, de façon à accélérer leur évacuation sans créer de zones de stagnation ou de circulation turbulente qui entretiendrait une telle stagnation, résultent de la conjonction des éléments suivants :

- les moyens d'injection d'azote localisés en VI, dans la zone de cuisson, sont tels que cette injection d'azote n'a plus lieu verticalement, comme c'était le cas auparavant, mais est orientée vers l'emplacement des moyens d'extraction, comme indiqué par les flèches sur la figure 1, suivant un angle $\alpha$ non nul inférieur à 45°. De plus ces moyens sont tels que les tubes d'injection sont munis de trous de section relativement élevée (leur diamètre étant avantageusement supérieur à 3 mm). Cette dernière caractéristique permet d'éviter une aspiration d'air par la sortie du four. L'acquisition de la vitesse du flux d'azote, permettant, en conjonction avec l'orientation adéquate de ce flux, d'assurer un régime non turbulent et une bonne évacuation des gaz réducteurs est ensuite obtenue du seul fait de la température élevée régnant dans cette zone.

- De même l'injection d'azote assurée dans la zone de précuisson par les moyens localisés en V est orientée en direction des moyens d'extraction suivant un angle $\beta$ compris entre 20 et 45°. Ceci permet de renforcer le phénomène de balayage précédemment créé sans créer de régime turbulent et de compenser la perte de vitesse du flux d'azote due à la diminution de la température dans la zone de précuisson. Une autre caractéristique tendant au même résultat consiste dans le fait que les tubes d'injection d'azote dans la zone de précuisson sont munis de trous de section relativement faible (par exemple inférieur ou égal à 2 mm). Une autre caractéristique tendant également au même résultat consiste dans le fait que les tubes d'injection d'azote dans la zone de précuisson sont en nombre relativement important (de préférence supérieur à cinq) et sont alimentés par des débimètres indépendants, tels que 4, de manière à compenser les différences de vitesse du flux d'azote dues aux différences de température régnant entre les différents points d'implantation de ces tubes dans cette zone.

Une autre caractéristique tendant au même résultat consiste encore dans le fait que les moyens d'injection d'azote dans la zone de précuisson sont localisés dans une zone comprise entre 450°C et 800°C, soit après la zone de formation des gaz réducteurs et non pas au-dessus de cette Zone.

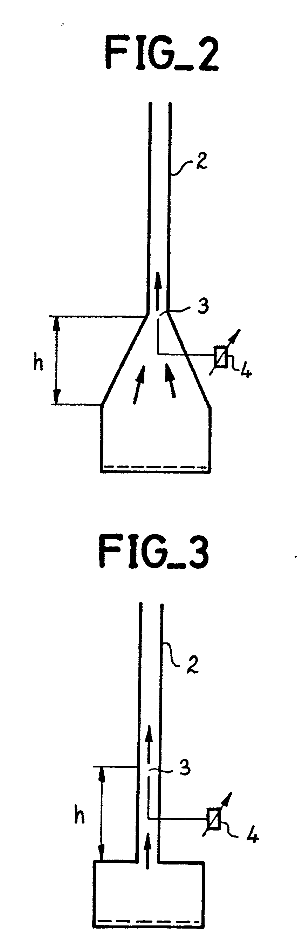

- les moyens d'extraction des gaz réducteurs ne sont plus localisés n'importe où, comme cela pouvait être le cas auparavant, mais au plus près de la zone où se produisent les réactions aboutissant à la formation de ces gaz (soit entre 250°C et 500°C, de façon à éviter le plus possible une stagnation de ces gaz au-dessus du substrat. Ceci vient donc renforcer le phénomène de balayage (symbolisé par les flèches en traits plus épais de la figure 1) en contribuant à assurer une évacuation plus rapide et plus efficace de ces gaz. Dans cette même optique le système d'injection 3 équipant la cheminée 2 est placé au plus près de la base de la cheminée, et de préférence à une hauteur h inférieure à 200 mm, comme cela apparaît sur les figures 2 et 3 qui représentent deux exemples de réalisation d'un tel système d'extraction. Sur ces schémas apparaissent la cheminée 2, l'injecteur 3 et le débimètre 4 commandant ce système d'injection.

Il faut souligner que si le four suivant l'invention est particulièrement intéressant, voire indispensable, pour la cuisson sous atmosphère non oxydante, il peut également être utilisé avec profit pour la cuisson sous air.

## Revendications

1. Four de cuisson de substrat de circuit imprimé obtenu par dépôt sérigraphique, sur un substrat isolant, d'une encre isolante ou résistive comportant un matériau organique qui constitue un lien temporaire de cette encre, four muni de moyens d'injection de gaz permettant la cuisson sous l'atmosphère souhaitée, successivement dans une zone de précuisson (II) et dans une zone de cuisson (III), de moyens d'extraction (2) des gaz réducteurs obtenus par transformation des matériaux organiques sous l'effet de la température dans la zone de précuisson et positionnés à proximité de cette zone de précuisson, et de moyens pour assurer un balayage de ces gaz réducteurs en direction des moyens d'extraction, caractérisé en ce que les moyens de balayage comportent des moyens d'injection des gaz (V) dans la zone de précuisson (II) qui sont orientés en direction des moyens d'extraction suivant un an angle compris entre 20° et 45° et des moyens d'injection des gaz (VI) dans la zone de cuisson (III) qui sont orientés d'un angle non nul inférieur à 45° en direction des moyens d'extraction (2) des gaz réducteurs.

2. Four selon la revendication 1, caractérisé en ce que le diamètre des trous des moyens d'injection (V) de gaz dans la zone de précuisson (II) est inférieur ou égal à 2 mm.

3. Four selon la revendication 1 caractérisé en ce que le diamètre des trous des moyens d'injection (VI) de gaz dans la zone de cuisson (III) est supérieur à 3 mm.

4. Four selon l'une des revendications 1 à 3, caractérisé en ce que les moyens d'injection de gaz dans la zone de précuisson (II) comportent des tubes en nombre supérieur à 5.

5. Four selon l'une des revendications 1 à 4, caractérisé en ce que les tubes des moyens d'injection (V) de gaz dans la zone de précuisson (II) sont localisés après la zone de formation des gaz réducteurs.

6. Four selon l'une des revendications 1 à 5, caractérisé en ce que les tubes des moyens d'injection de gaz dans la zone de précuisson (II) sont alimentés de façon indépendante l'un de l'autre.

## Claims

1. An oven for heating a PCB substrate produced by screen printing on an insulating substrate using an insulating or resist ink comprising an organic material which constitutes a temporary connection for the ink, said oven being fitted with gas injection means making possible baking in the desired atmosphere successively in a prebake zone (II) and in a bake zone (III), means (2) for exhausting the reducing gases obtained by the transformation of the organic materials under the effect of the heat in the prebake zone and positioned in the vicinity of the prebake zone, and means in order to ensure the scavenging of the reducing gas into exhaust means, characterized in that the sweeping means comprise means (V) for the injection of gas into the prebake zone (II) which are directed towards the exhausting means at an angle comprised between 20° and 45° and means (VI) for the injection of gas into the bake zone (III) which are directed at an angle, other than zero, under 45° towards exhaust means (2) for the reducing gases.

2. The oven as claimed in claim 1, characterized in that the diameter of the holes of the means (V) for injecting gas into the prebake zone (II) is less than or equal to 2 mm.

3. The oven as claimed in claim 1, characterized in that the diameter of the holes of the means (VI) for injecting gas into the bake zone (III) is greater than 3 mm.

4. The oven as claimed in any one of the preceding claims 1 through 3, characterized in that the means for the injection of gas into the prebe zone (II) comprise tubes whose number is greater than 5.

5. The oven as claimed in any one of the preceding claims 1 through 4, characterized in that the tubes of the means (V) for the injection of the gas into the prebake zone (II) are positioned downstream from the zone of formation of the reducing gases.

6. The oven as claimed in any one of the preceding claims 1 through 5, characterized in that the tubes of the means for the injection of the gas into the prebake zone (II) are fed in a manner independent from each other.

## Patentansprüche

1. Ofen zum Brennen des Substrats einer gedruckten Schaltung, die auf einem isolierenden Substrat durch den serigraphischen Niederschlag einer isolierenden oder resistiven Tinte, die ein eine vorübergehende Verbindung dieser Tinte bildendes organisches Material enthält, erhalten wird, wobei der Ofen mit Mitteln zum Einlassen von Gas, die die Verbrennung in einer gewünschten Atmosphäre nacheinander in einer Vorbrennzone (II) und in einer Brennzone (III) gestatten, in der Nähe dieser Vorbrennzone angeordneten Mitteln (2) zum Extrahieren der reduzierenden Gase, die durch die Umwandlung der organischen Materialien unter der Wirkung der Temperatur in der Vorbrennzone erhalten werden, und Mitteln zum Sicherstellen einer Spülung dieser reduzierenden Gase in Richtung der Extraktionsmittel versehen ist, dadurch gekennzeichnet, daß die Mittel zum Spülen Mittel zum Einlassen von Gasen (V) in die Vorbrennzone (II), die in Richtung der Extraktionsmittel in einem Winkel zwischen 20° und 45° orientiert sind, und Mittel zum Einlassen von Gasen (VI) in die Brennzone (III), die in einem von Null verschiedenen Winkel, der kleiner als 45° ist, in Richtung der Mittel (2) zum Extrahieren der reduzierenden Gase orientiert sind, umfassen.

2. Ofen gemäß Anspruch 1, dadurch gekennzeichnet, daß der Durchmesser der Löcher der Mittel (V) zum Einlassen von Gas in die Vorbrennzone (II) kleiner oder gleich 2 mm ist.

3. Ofen gemäß Anspruch 1, dadurch gekennzeichnet, daß der Durchmesser der Löcher der Mittel (VI) zum Einlassen von Gas in die Brennzone (III) größer als 3 mm ist.

4. Ofen gemäß einem der Ansprüche 1 bis 3, dadurch gekennzeichnet, daß die Mittel zum Einlassen von Gas in die Vorbrennzone (II) Rohre in einer Anzahl, die größer als 5 ist, enthalten.

5. Ofen gemäß einem der Ansprüche 1 bis 4, dadurch gekennzeichnet, daß die Rohre der Mittel (V) zum Einlassen von Gas in die Vorbrennzone (II) hinter der Zone zur Ausbildung der reduzierenden Gase angeordnet sind.

6. Ofen gemäß einem der Ansprüche 1 bis 5, dadurch gekennzeichnet, daß die Rohre der Mittel zum Einlassen von Gas in die Vorbrennzone (II) unabhängig voneinander versorgt werden.

# FIG_1

EP 0 202 988 B1

# FIG_2

# FIG_3